Europäisches Patentamt

European Patent Office

Office européen des brevets

(11) Publication number: **0 311 146**
**A1**

## (12) EUROPEAN PATENT APPLICATION

(21) Application number: 88118696.9

(22) Date of filing: 22.11.82

(51) Int. Cl.⁴: **G11C 11/34 , G11C 17/00 , G11C 11/00**

(30) Priority: 23.11.81 US 324343
23.11.81 US 324344

(43) Date of publication of application:
**12.04.89 Bulletin 89/15**

(60) Publication number of the earlier application in accordance with Art.76 EPC: **0 080 415**

(84) Designated Contracting States:
**DE FR GB IT NL**

(71) Applicant: **FAIRCHILD SEMICONDUCTOR CORPORATION**
**2900 Semiconductor Drive**
**Santa Clara California 95052(US)**

(72) Inventor: **Tickle, Andrew C.**
**1222 Richardson Avenue**
**Los Altos, Calif. 94022(US)**

(74) Representative: **Dipl.-Ing. H. Marsch Dipl.-Ing.**
**K. Sparing Dipl.-Phys.Dr. W.H. Röhl**
**Patentanwälte**
**Rethelstrasse 123**
**D-4000 Düsseldorf 1(DE)**

(54) **Self-refreshing memory cell.**

(57) A nonvolatile static random access memory cell (110) includes a pair of cross-coupled transistors (T1,T2) which function as a bistable circuit to store data states. Variable threshold transistor (M1,M2) are respectively connected in series between the driver transistors (T1,T2) and load devices (R1,R2). A control node (97) is driven to a high voltage state to cause one of the variable threshold transistors (M1,M2) to be driven to have a higher threshold voltage and thereby store the data state held in the cross-coupled transistors (T1,T2). The data state is thus stored in nonvolatile form. Upon recall the memory cell (110) is reactivated and the threshold differential between the variable threshold transistors (111,112) causes the driver transistors (T1,T2) to be set at the stored data state. The data recalled by the memory cell (110) is in true rather than in complementary form.

FIG.2

CELL ELECTRICAL
CONFIGURATION

EP 0 311 146 A1

## SELF-REFRESHING MEMORY CELL

### BACKGROUND OF THE INVENTION

### Field of the Invention

This invention relates to a self-refreshing memory cell suitable for use in an integrated circuit with increased packing density over circuits of the prior art, and to its method of operation.

### Prior Art

Bistable memory cells are well known. Such cells are disclosed, for example, in United States Patent No. 3,562,721 to Norman, issued February 9, 1971. The Norman cell comprises two cross-coupled bipolar transistors connected in what has now become a standard bistable flip-flop configuration. The collector of one bipolar transistor in the cell is connected to the base of the other transistor and the emitters of the two transistors are grounded. When one transistor turns on, the collector voltage on that transistor drops thereby turning off the other transistor. The collector voltage on the off transistor then rises turning on harder the "on" transistor. The state of the cell is changed by pulsing simultaneously the collector of the cross-coupled transistor and a selected switching transistor. The state of the cell is sensed by determining the voltages on the collectors of the two transistors.

Since the disclosure of this long established cell, new bistable cells have appeared, including cells using a charge stored at the interface between two dissimilar dielectrics (see, for example, U.S. Patent No. 3,641,512 issued February 8, 1972 on an invention of Frohman-Bentchkowsky) and cells using so-called "floating gates" which are conductive gates insulated from the active components of the transistor by dielectric. The charge on the floating gate is often controlled by controlling the potential on an overlying word line in such a manner as to either draw a charge from an underlying source to the floating gate or expel charge from the floating gate to the source. Such devices, often making use of electron tunnelling through a thin dielectric, are described, for example, in an article entitled "Low Power EEPROM Can be Reprogrammed Fast", published in Electronics, July 31, 1980, by Shelton. The EEPROM, short for "Electrically Erasable Programmable Read Only Memory", has distinct advantages over the prior art memories in that the EEPROM can be erased by programming internal to the chip whereas the standard EPROM is erasable only by UV light from an external source. In addition, the EEPROM lends itself to rapid reprogramming in a simple manner with portable equipment.

### SUMMARY OF THE INVENTION

This invention turns to advantage several previously thought disadvantages of the prior art bistable memory cell and combines these features with a floating gate structure to yield an EEPROM device which, surprisingly, is self-refreshing.

In accordance with one embodiment of this invention, two transistors are coupled in a bistable configuration with a floating gate sandwiched between the gate electrode and the channel region of one transistor and connected by means of tunnel oxide to a portion of the drain of the other transistor. The result is that disturbances on the voltage supply reinforce the bias charge on the floating gates and therefore reinforce the state of the cell, rather than disturb and degrade the state of the cell. Consequently, the cell is self-refreshing.

In accordance with another embodiment of this invention, two transistors are cross-coupled in a standard bistable flip-flop configuration with the gate electrode of a first transistor coupled to the drain of the second transistor. A separate load resistor connects the drain of each of the two cross-coupled transistors to a power supply. However, connected in series with each load resistor between the load resistor and the drain of its corresponding transistor is a floating gate MOS transistor of this invention. The floating gate of each transistor is separated from the underlying source, drain and channel regions of the transistor by dielectric, a portion of which is of reduced thickness over a portion of the drain. Therefore, the floating gate of each transistor is capable of having electrons tunneled to or from it through the tunnel oxide from or to its underlying drain. Consequently, this cell also is self-refreshing.

This invention provides structures which resemble conventional cross-coupled flip-flops. However, contrary to such flip-flops, the coupling in the flip-flops of this invention is AC rather than DC. The flip-flops of this invention may be written into and read from in a conventional manner. However, since the drain voltage on the active element which is off is always in the same direction as for writing, drain disturb reinforces writing assuming that the volatile information stored in the cell is the same as the non-volatile state of the cell. Should these two states be different, then a normal disturb will degrade, rather than reinforce, writing.

This invention will be more fully understood in light of the following description taken together with the drawings.

## DESCRIPTION OF THE DRAWINGS

Figure 1 shows graphically an example of the change in threshold voltage with time for the structure of this invention;

Figure 2 is a schematic diagram of another embodiment of this invention; and

Figures 3a and 3b illustrate in cross-section the floating gate and tunnel oxide structures of a type useful in the semiconductor integrated circuit implementations of the circuits of this invention.

## DETAILED DESCRIPTION

This invention will be described in conjunction with two embodiments. It should be understood, however, that this description is illustrative only and is not meant to limit the scope of the invention.

Two types of memories are commonly employed-volatile and non-volatile. A volatile memory is one which loses the information stored therein immediately upon loss of power. A non-volatile memory is one which retains the information stored therein despite the loss of power. As will be seen shortly, memory cell 10 is capable of storing both volatile and non-volatile information.

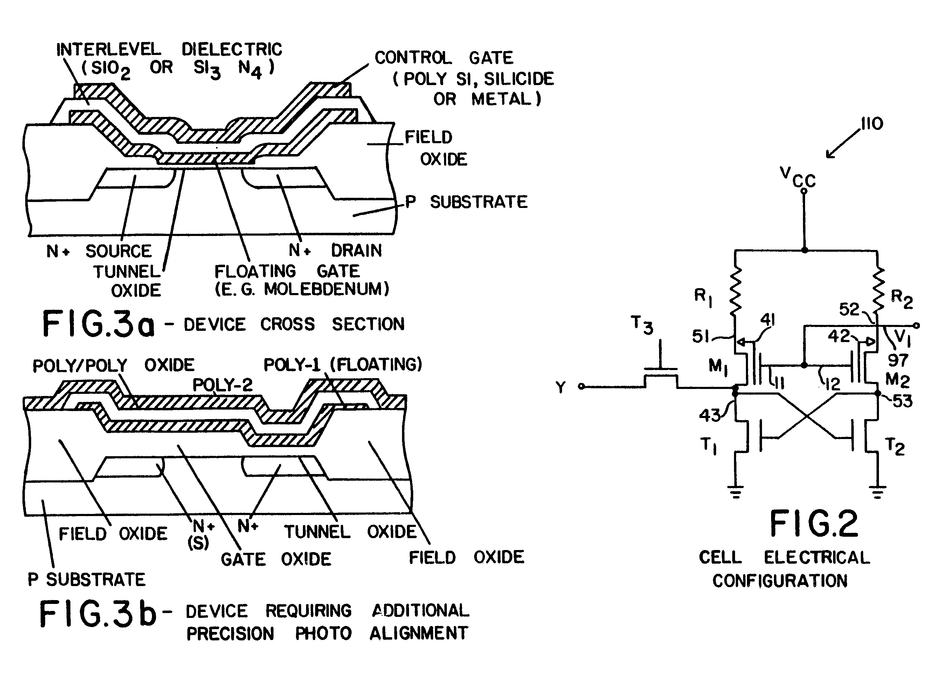

Figure 2 shows another embodiment of this invention. In Figure 2, resistors $R_1$ and $R_2$ (which may be, for example, active MOS transistor loads or polysilicon resistors) and conventional MOS transistors $T_1$ and $T_2$ form a conventional cross-coupled static flip-flop such as disclosed, for example, in Craft et al. United States Patent No. 3,530,443. However, in accordance with this invention, memory transistors $M_1$ and $M_2$ are added between resistors $R_1$ and $R_2$ and transistors $T_1$ and $T_2$, respectively.

In describing the operation of memory cell 110 in this specification, certain conventions will be adopted. Thus, the storage in a volatile manner of a logical one within memory cell 110 of Figure 2 will correspond to transistor $T_1$ nonconducting and transistor $T_2$ conducting. Similarly, the storage in a volatile manner of a logical zero within memory cell 110 will correspond to transistor $T_1$ conducting and transistor $T_2$ nonconducting. The storage in a non-volatile manner of a logical one within memory cell 11 corresponds to a threshold voltage of transistor $M_1$ which is less than the threshold voltage of transistor $M_2$, and the storage in a non-volatile manner of a logical zero corresponds to a threshold voltage of transistor $M_1$ which is greater than the threshold voltage of transistor $M_2$. These conventions are summarized in Table II (where $V_t$ represents threshold voltage).

### TABLE II

### Cell 110 (Figure 2)

| | | $M_1$ | | $M_2$ | $T_1$ | $T_2$ |
|---|---|---|---|---|---|---|
| Volatile | 0 | | | | On | Off |
| Storage | 1 | | | | Off | On |
| Non-volatile | 0 | $V_{t1}$ | > | $V_{t2}$ | On | Off |
| Storage | 1 | $V_{t1}$ | < | $V_{t2}$ | Off | On |

If voltage $V_1$ applied to gates 11 and 12 of transistors $M_1$ and $M_2$ respectively is sufficiently high to turn on both transistors $M_1$ and $M_2$, the memory cell 110 functions as a volatile flip-flop, with its logical state (zero or one) being determined by the data input signal placed on node 43. A data input signal is provided on lead Y through gating transistor $T_3$ to node 43. This data input signal is high and is approximately equal to $V_{CC}$ (e.g. both the high data input signal and $V_{CC}$ are approximately 5 volts) if a one is to be written into cell 10 and is low (e.g. approximately 0 volts) if a zero is to be written into cell 10. The data input signal on node 43 is capacitively coupled to floating gate 15 of transistor $M_2$. Furthermore, the logical state of memory cell 110 is read, by suitable sense amplifiers (not shown) connected to node 43 through gating transistor $T_3$ and lead Y. The sense amplifier is capable of providing an output signal corresponding to a logical 1 when node 43 is high (transistor $M_1$ nonconducting and transistor $M_2$ conducting), and an output signal corresponding to a logical low when the voltage on node 43 is low (transistor $M_1$ conducting and transistor $M_2$ nonconducting).

If memory transistor $M_1$ and $M_2$ are turned on and have equal threshold voltages, then transistors $M_1$ and $M_2$ have no effect on the operation of the flip-flop formed by transistors $T_1$ and $T_2$ and the state of the flip-flop is set by the level of the signal on lead Y. On the other hand, if, for example, a logical one has been stored in cell 110 in a non-volatile manner, transistor $M_1$ has a lower threshold voltage than transistor $M_2$. The transistor with the lower threshold ($M_1$) will determine the state of the flip-flop comprising transistors $T_1$ and $T_2$ when voltages $V_{CC}$ and $V_1$ are initially applied to the device. Thus, if signal $V_1$ is supplied on lead 97 to the gates 11 and 12 of transistors $M_1$ and $M_2$, respectively, and $V_{CC}$ is on, transistor $M_1$ turns on first, thereby allowing $V_{cc}$ to be applied to the gate of transistor $T_2$, thereby turning on transistor $T_2$. The turning on of transistor $T_2$ causes node 53, connected to the gate of transistor $T_1$, to be substantially at ground, thus preventing transistor $T_1$ from turning on. Thus, the non-volatile storage of a logical one in memory cell 110 results in the setting of the flip-flop formed by transistors $T_1$ and $T_2$ to a logical one during power-up.

On the other hand, if a logical zero has been stored in cell 110 in a non-volatile manner, transistor $M_1$ has a higher threshold voltage than transistor $M_2$. When signal $V_1$ is supplied on lead 97 to the gates 11 and 12 of transistors $M_1$ and $M_2$ respectively, transistor $M_2$ turns on first, thereby allowing $V_{cc}$ to be applied to the gate of transistor $T_1$, thereby turning on transistor $T_1$. The turning on of transistor $T_1$ causes node 43, connected to the gate of transistor $T_2$, to drop substantially to ground, thus preventing transistor $T_2$ from turning on. Thus, the storage of a logical zero in memory cell 110 results in the setting of the flip-flop formed by transistors $T_1$ and $T_2$ to a logical zero upon power-up.

Programming cell 110 in a non-volatile manner is accomplished by controlling the threshold voltages of transistors $M_1$ and $M_2$. The threshold voltages of transistors $M_1$ and $M_2$ can be controlled by the charges on the floating gates 41 and 42 of these two transistors. Thus, the removal of electrons from floating gate 41, for example, lowers the threshold voltage of transistor $M_1$ when transistor $M_1$ is an N channel device and similarly, the addition of electrons to the floating gate 41 of transistor $M_1$ raises the threshold voltage of $M_1$ when $M_1$ is an N channel device.

The state of the cell 110 is programmed in a non-volatile manner as follows. The threshold voltages of transistors $M_1$ and $M_2$ are written by raising the supply voltage $V_{CC}$ to the writing voltage $V_W$ (typically 10-25 volts), with $V_1$ at ground. An external signal Y may be applied through transistor $T_3$ to drain 43 to determine the state of the cell to be programmed. Assuming a logical one is stored in cell 110 in a volatile manner, transistors $T_1$ and $M_1$ will be off and transistors $T_2$ and $M_2$ will be on. When $V_{CC}$ reaches $V_W$, writing (decreasing threshold) starts in $M_1$ and $M_2$. The drain voltage of transistor $M_1$ is substantially $V_W$ and electrons are drawn from floating gate 41 to drain 51 through tunnel oxide located between the floating gate 41 and the drain 51 of transistor $M_1$, thereby decreasing the threshold voltage of transistor $M_1$ relative to the threshold voltage of transistor $M_2$. Because $T_2$ is on and trying to conduct current, $M_2$ will turn on and conduct as soon as its threshold crosses the depletion level (negative threshold). The voltage drop across $R_2$ then reduces the drain voltage on drain 52, thereby limiting further writing. Because $T_1$ is off, $M_1$ cannot conduct and thus transistor $M_1$ moves further into depletion (i.e. further on) than $M_2$. As the drain 52 and the floating gate 42 of transistor $M_2$ drops from $V_W$ (the writing voltage) tunnelling of electrons between floating gate 42 and drain 52 of transistor $M_2$ stops.

Alternatively, if a logical zero is stored in cell 110 in a volatile manner, transistors $T_1$ and $M_1$ will be on and transistors $T_2$ and $M_2$ will be off. Because transistor $T_2$ is off, the gate voltage on transistor $T_1$ is relatively high-level, therefor holding transistor $T_1$ on. Transistors $T_2$ and $M_2$ are not conducting; thus drain 52 of transistor $M_2$ is substantially at $V_{CC}$. Raising $V_{CC}$ to the high level write voltage $V_W$ results in electrons tunnelling from the floating gate 42 of transistor $M_2$ through the tunnel oxide to the drain 52 of transistor $M_2$ in a manner analogous to that described above for the storage of a logical one. Therefore the threshold voltage of transistor $M_2$ decreases relative to the threshold voltage of transistor $M_1$.

Upon power-up of memory cell 11, a voltage $V_1$ (typically the same as $V_{cc} = 5$ volts) is supplied to gates 11 and 12 of transistors $M_1$ and $M_2$ respectively. The transistors $M_1$ or $M_2$ having the lower threshold voltage will turn on first, thus determining the state of the flip-flop formed by transistors $T_1$ and $T_2$. For

example, if a logical one was stored in memory cell 110 in a non-volatile manner prior to power-down, the threshold voltage of transistor $M_1$ will be less than the threshold voltage of transistor $M_2$. Thus, upon power-up, transistor $M_1$ turns on first, applying $V_{cc}$ through resistor $R_1$ to node 43 connected to the gate of transistor $T_2$, thus causing transistor $T_2$ to turn on. With transistor $T_2$ conducting, drain 53 of transistor $T_2$ is substantially at ground, thus preventing transistor $T_1$ from turning on. Thus the flip-flop comprising transistors $T_1$ and $T_2$ is set to a logical one.

On the other hand, if a logical zero was stored in memory cell 110 in a non-volatile manner prior to power-down, the threshold voltage of transistor $M_2$ is less than the threshold voltage of transistor $M_1$. Thus, on power-up, a voltage $V_1$ is applied to gates 11 and 12 of transistors $M_1$ and $M_2$ respectively, and $V_{CC}$ is supplied to the circuit, causing transistor $M_2$ to turn on before transistor $M_1$ turns on. With transistor $M_2$ turned on, a high voltage is applied from $V_{cc}$ through $R_2$ to node 53 connected to the gate of transistor $T_1$. Transistor $T_1$ then turns on, driving the voltage on node 43 applied to the gate of transistor $T_2$ to ground. Thus transistor $T_2$ is prevented from turning on, and the flip-flop comprising transistors $T_1$ and $T_2$ is set to a logical zero.

In order to store the state of the flip-flop in a non-volatile manner, $V_{cc}$ is raised to the writing voltage $V_w$ (approximately 10-25 volts). The effect of this writing voltage $V_w$ is to draw electrons from the floating gate of the non-conducting transistor $M_1$ or $M_2$, thereby lowering the threshold voltage of the non-conducting transistor M1 or M2. For example, if a logical one is written in cell 11 in a volatile manner, transistor T1 will be off, and thus transistor M1 will be non-conducting, and transistor $T_2$ will be on and thus transistor $M_2$ will be conducting. With $V_{cc}$ equal to the writing voltage $V_w$, the drain 51 is essentially $V_w$, thus causing electrons to tunnel from floating gate 41 to drain 51, thus decreasing the threshold voltage of transistor $M_1$. Because transistors $M_2$ and $T_2$ are conducting, drain 52 is substantially at ground, thus preventing the tunnelling of electrons from floating gate 42 to drain 52 of transistor $M_2$. On the other hand, if a logical 0 is contained in a volatile manner in cell 11, and $V_{cc}$ is raised to $V_w$, transistors $M_2$ and $T_2$ will be non-conducting, and drain 52 will be essentially at $V_w$ $V_w$. This causes electrons to tunnel from floating gate 42 to drain 52 of transistor $M_2$, thus decreasing the threshold voltage of transistor $M_2$. With transistors $M_1$ and $T_1$ conducting, drain 51 is essentially at ground, thus preventing the tunnelling of electrons from floating gate 41 to drain 51 of transistor $M_1$. Thus, the threshold voltage of transistor $M_2$ is made lower than the threshold voltage of transistor $M_1$, corresponding to the non-volatile storage of a logical 0 in cell 110.

The self-refreshing nature of the cell 11 during normal operation ($V_{cc}$ = 5 volts) becomes apparent from the following explanation. With transistor $T_1$ not conducting, the drain 51 of transistor $M_1$ will always be at $V_{cc}$ (typically 5 volts). This is sufficient to cause a slow writing effect reinforcing the stored data as shown in Figure 3. $M_2$ has a voltage close to ground at its drain and therefor has no reinforcing disturbing effect.

To erase data stored in a non-volatile manner within the memory cell 11, the circuit is unpowered ($V_{CC}$ floating or zero volts) and $V_1$ is set at the erase voltage $V_E$ (typically +20 to +25 volts). The thresholds of transistors $M_1$ and $M_2$ will be increased to an equal level by the tunneling of electrons to floating gates 41 and 42 from drains 51 and 52, respectively. Erasure typically takes a few seconds.

Erasure may also be performed with the circuit active ($V_{CC}$=5 volts) since $V_E$ turns $M_1$ and $M_2$ on harder and does not affect the state of the flip-flop. However, the presence of a positive voltage on the drain of either transistor 43 or 53 during active operation of the memory cell 11 slightly reduces the erasing effectiveness of that transistor. This would result in a difference between the threshold voltages of transistors $M_1$ and $M_2$. If the erasure is performed with memory cell 110 active, the signal Y used to set the state of the transistors $M_1$, $M_2$ and $T_1$ and $T_2$ during volatile operation must override this threshold difference, allowing both transistors $M_1$ and $M_2$ to conduct during volatile operation of memory cell 110.

The cell of Figure 2 may be used as a non-volatile static RAM in which the flip-flop operates as a normal active memory cell. Then prior to powering down, provided that the cell has previously been erased, $V_{CC}$ is raised to $V_w$ for a few milliseconds to provide non-volatile storage until power is restored. The data transfer to non-volatile storage occurs simultaneously for all bits in the memory. Also, two bits may be stored in each cell, one volatile and the other non-volatile.

High temperature and high reliability margins are increased for the cells of this invention since the write disturb increases margins rather than reducing them. The circuits of this invention are particularly useful in a family of erasable memories compatible with UV erasable EPROMS for fault isolating decoders. The disclosed structures are compatible with existing standard products and are useful in high reliability and high temperature circuits. The circuits are advantageous because they can be erased and altered in the system.

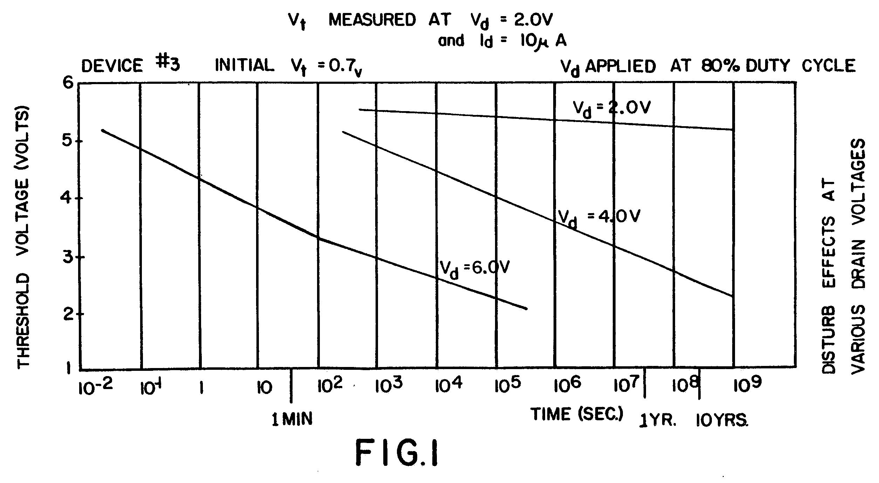

Figure 3a illustrates in cross section a semiconductor device particularly suited for implementing the structure shown in Figure 1. P-type substrate (typically <100> material with resistivity of 2-50 -cm) has formed in it N+ source and drain regions using well-known processing techniques. Formed over the

5

surface of the active region of the device is a gate oxide and formed over the gate oxide is a floating gate of a conductive material such as doped polycrystalline silicon or molybdenum. On top of the floating gate is formed dielectric (typically silicon dioxide or silicon nitride) and on top of this dielectric is formed a control gate. The control gate is again formed of doped polycrystalline silicon, a silicide or selected metal such as aluminum and is capacitively coupled to the floating gate. As shown in Figure 3b, the tunnelling oxide portion is formed directly over the drain such that electrons can tunnel in response to the proper voltages applied to the drain and the floating gate from one to the other. Overlying the floating gate but separated therefrom by dielectric is a control gate typically formed of doped polycrystalline silicon. This control gate is capacitively coupled to the floating gate so as to control the potential of the floating gate.

Other embodiments of this invention will be obvious to those skilled in the art in view of this disclosure.

**Claims**

1. A memory cell comprising:
a first MOS transistor (T1) and a second MOS transistor (T2), each of said first and second MOS transistors possessing a source, a drain, and a control gate;
a third MOS transistor (M1) and a fourth MOS transistor (M2), each of said third and fourth MOS transistors possessing a source, a drain and a control gate;
a first floating gate (41) positioned between the gate (11) and the channel of said third MOS transistor (M1) but insulated therefrom and having a portion extending above but separated by dielectric from the drain (51) of said MOS transistor (M1), said dielectric having a portion thereof sufficiently thin to allow electrons to tunnel therethrough between the drain (51) of said third MOS transistor (M1) and said first floating gate (41);
a second floating gate (42) positioned between the gate (12) and the channel of said fourth MOS transistor (M2) but insulated therefrom and having a portion extending above but separated by dielectric from the drain of said fourth MOS transistor (M2), said dielectric having a portion thereof sufficiently thin to allow electrons to tunnel therethrough between the drain of said fourth MOS transistor (M2) and said second floating gate (42);
characterized by:
a pair of resistive elements (R1, R2), one lead of each resistive element being connected to a corresponding drain of one of said third and fourth MOS transistors (M1, M2), the other lead of each resistive element being connected to a voltage source (V$_{cc}$);
means connecting the control gates (11, 12) of said third and fourth MOS transistors (M1, M2) to a source of gate potential (V1);
means connecting the control gate of said first MOS transistor (T1) to the drain of said second MOS transistor (T2);
means connecting the control gate of said second MOS transistor (T2) to the drain of said first MOS transistor (T1); and
means connected to the drain of said first MOS transistor (T1) for providing a signal to said memory circuit, thereby to control the state of said memory circuit, and for reading out in response to selected signals the state of said memory circuit.

2. Structure as in claim 1, characterized in that said means for providing a signal to and for reading out the state of said memory circuit includes:
means for applying a first or a second signal to said memory cell thereby to control the state of said memory cell;
means for sensing the state of said memory cell; and
means for coupling said means for applying and said means for sensing to said memory cell.

3. Structure as in claim 2, characterized in that said means for coupling comprises a switching transistor (T3).

DEVICE #3   INITIAL $V_t$ = 0.7$_v$   $V_t$ MEASURED AT $V_d$ = 2.0V
and $I_d$ = 10$\mu$A   $V_d$ APPLIED AT 80% DUTY CYCLE

DISTURB EFFECTS AT VARIOUS DRAIN VOLTAGES

$V_d$ = 2.0V

$V_d$ = 4.0V

$V_d$ = 6.0V

TIME (SEC.)

THRESHOLD VOLTAGE (VOLTS)

1 MIN   1 YR.   10 YRS.

FIG. I

INTERLEVEL DIELECTRIC
(SIO$_2$ OR SI$_3$ N$_4$)

CONTROL GATE
(POLY SI, SILICIDE
OR METAL)

FIELD
OXIDE

P SUBSTRATE

N+ SOURCE

N+ DRAIN

TUNNEL
OXIDE

FLOATING GATE
(E.G. MOLEBDENUM)

FIG.3a - DEVICE CROSS SECTION

POLY/POLY OXIDE

POLY-1 (FLOATING)

POLY-2

FIELD OXIDE

N+
(S)

N+

TUNNEL OXIDE

GATE OXIDE

FIELD OXIDE

P SUBSTRATE

FIG.3b - DEVICE REQUIRING ADDITIONAL
PRECISION PHOTO ALIGNMENT

110

V$_{CC}$

R$_1$

R$_2$

T$_3$

51

41

52

42

V$_1$

M$_1$

11

12

97

Y

M2

43

53

T$_1$

T$_2$

FIG.2

CELL ELECTRICAL
CONFIGURATION

EP 0 311 146 A1

European Patent Office

EUROPEAN SEARCH REPORT

Application Number

EP 88 11 8696

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| Y | GB-A-2 000 407 (HUGHES) <br> * Page 1, lines 20-54; page 6, line 58 - page 7, line 27; figures 3,6-10 * <br> --- | 1-3 | G 11 C 11/34 <br> G 11 C 17/00 <br> G 11 C 11/00 |
| Y | US-A-3 636 530 (LITTON) <br> * Column 1, line 60 - column 3, line 2; figure 1 * <br> --- | 1-3 | |
| A | FR-A-2 300 391 (HONEYWELL) <br> * Text relating to figure 1; figure 1 * <br> --- | 1-3 | |
| A | US-A-4 090 259 (WILCOCK) <br> * Column 3, lines 11-35; figures 1,7 * <br> --- | 1-3 | |
| A | GB-A-2 058 451 (PLESSEY) <br> * Page 3, lines 18-127; figure 5 * <br> --- | 1-3 | |
| A | EP-A-0 028 935 (HUGHES) <br> * Page 4, lines 19-34; figures * <br> --- | 1-3 | |
| E | US-A-4 460 978 (MOSTEK) <br> * Column 2, line 15 - column 4, line 16; figures * <br> ----- | 1-3 | **TECHNICAL FIELDS SEARCHED (Int. Cl.4)** <br><br> G 11 C 11/00 |

The present search report has been drawn up for all claims

| Place of search | Date of completion of the search | Examiner |
|---|---|---|
| THE HAGUE | 20-01-1989 | NUSSBAUMER C.P. |